# EUROPEAN PATENT APPLICATION

(11) **EP 4 764 867 A1**
(43) Date of publication of application: **24.06.2026**
(21) Application number: 25221571.0
(22) Date of filing: 08.12.2025
(51) Int. Cl.: G06F 11/362

(54) **HARDWARE-BASED TRIGGER POINT INSTRUMENTATION CIRCUIT**

(30) Priority: 17.12.2024 US 202418984457
(71) Applicant: NXP B.V., 5656 AG Eindhoven (NL)
(72) Inventor: Cioranesco, Jean-Michel, 5656AG Eindhoven (NL); Diehl, Oliver, 5656AG Eindhoven (NL); Bezsmertnyi, Volodymyr, 5656AG Eindhoven (NL)
(74) Representative: Krott, Michel

(57) **Abstract**

A system configured to assess the performance of a program includes a processor to execute the program and a memory that stores lookup tables (LUTs) having entries that each indicate a point of interest in the program and a corresponding set of commands. In response to the processor reaching a trigger point in the program, a trigger point instrumentation circuit (TPIC) of the system determines the memory address currently accessed by the processor. The TPIC then performs a set of commands indicated in an entry of the LUTs based on the memory address currently accessed by the processor matching the point of interest indicated in the entry.

## Description

### BACKGROUND

To test software executed by a processing device such as a programmable logic device, processor, or the like, some systems include a debugging module that monitors for predetermined trigger points while the software is executing. For example, a host device modifies data stored in one or more registers of the debugging module so as to set hardware breakpoints that represent trigger points within the software being executed. When the processing device executing the software reaches one of these trigger points, the debugging module first pauses the execution of the software by the processing device. The host device then instructs the debugging module to read data from the registers of the processing device and uses the read-out data to assess certain metrics of the execution of the software. However, because the host device provides such instructions to the debugging module while the software is being executed, an overhead is introduced into the debugging process based on the time needed for the host device to communicate with the debugging module.

### BRIEF DESCRIPTION OF THE DRAWINGS

The present disclosure may be better understood, and its numerous features and advantages are made apparent to those skilled in the art by referencing the accompanying drawings. The use of the same reference symbols in different drawings indicates similar or identical items.
FIG. 1 is a block diagram of an example system that includes a hardware-based trigger point instrumentation circuit configured to execute sets of commands when points of interest in a program are reached, in accordance with some embodiments.
FIGs. 2 and 3 together present a flow diagram for an example operation that uses a hardware-based trigger point instrumentation circuit to execute sets of commands when a point of interest is reached, in accordance with some embodiments.
FIG. 4 is a flow diagram of an example operation for generating one or more lookup tables (LUTs) for a hardware-based trigger point instrumentation circuit, in accordance with some embodiments.
FIG. 5 is a diagram of an example LUT for a hardware-based trigger point instrumentation circuit, in accordance with some embodiments
FIG. 6 is a flow diagram of an example method for debugging a program using a hardware-based trigger point instrumentation circuit, in accordance with some embodiments.

### DETAILED DESCRIPTION

Systems and techniques disclosed herein include a system configured to assess the execution of one or more types of software by using a hardware-based trigger point instrumentation circuit to evaluate points of interest in the software (also referred to herein as a "program"). For example, the hardware-based trigger point instrumentation circuit (hereafter referred to as the "TPIC") is configured to evaluate a point of interest in a program by executing one or more sets of commands (e.g., gadgets) in response to a trigger point being reached in a currently executing program. These points of interest in a program, for example, include certain points within the program during which one or more instructions, memory locations, or both are to be evaluated so as to help assess the performance of the program. Additionally, such trigger points include one or more hardware breakpoints, watchpoints (e.g., memory watchpoints), and other address-based monitoring points associated with the program that are set by the system (e.g., set by a host device, debug circuitry, TPIC, or any combination thereof of the system). As an example, some trigger points (e.g., hardware breakpoints) represent the memory addresses of one or more instructions to be executed for a program. As another example, some trigger points (e.g., memory watch points) represent one or more memory addresses (e.g., memory addresses of registers, caches, memories, or the like) that are to be accessed (e.g., read from, written to, modify data in) while the program is executing. The types of programs (e.g., types of software) evaluated by the system include, for example, control software, media software, connectivity software, and the like.

To assess the execution of such programs, the debugging system includes a device under test (DUT) board or other test system that has one or more processors with processor cores configured to execute instructions for one or more programs to be assessed. As an example, within the DUT board, the processor is configured to execute one or more instructions, access one or more memory addresses, or both based on a machine-executable code (e.g., binary code) representing the program. Further, the DUT board includes debug circuitry that monitors the processor as the processor executes instructions for the program. As an example, while a processor is executing the program, the debug circuitry monitors the memory addresses (e.g., system memory addresses) of instructions executed by the processor, memory address accessed by the processor, or both until one or more trigger points are reached. That is to say, the debug circuitry monitors the processor executing the program to determine if the processor accesses a memory address corresponding to a trigger point (e.g., corresponding to a hardware breakpoint, watchpoint, or the like). In response to the processor reaching a trigger point (e.g., accessing a memory address corresponding to a trigger point), the debug circuitry determines that the trigger point has been reached and generates an interrupt configured to place the processor in a debugging mode so that the processor suspends execution of the program.

To determine how the system behaves based on the processor reaching a trigger point, the DUT board also includes a hardware-based trigger point instrumentation circuit (referred hereafter as "TPIC") configured to read, write, modify, or any combination thereof data at one or more memory addresses of one or more memory locations (e.g., general purpose registers (GPRs), control/status registers (CSRs), integer registers, caches, memories) based on certain points of interest within the program. For example, the TPIC includes an integrated circuit with one or more microcontrollers, microprocessors, programmable logic devices, storages, buffers, or any combination thereof configured to execute one or more sets of commands (e.g., gadgets) based on a point of interest being reaching in the program. To this end, the TPIC includes or otherwise has access to a TPIC memory configured to store one or more LUTs including data indicating one or more points of interest within a program. For example, the LUTs include data indicating memory addresses each associated with a corresponding point of interest for the program, gadgets (e.g., sets of commands) to be executed for these points of interest, successor points of interest (e.g., points of interest expected to be executed after an initial point of interest), or any combination thereof. Such points of interest in an LUT, for example, each correspond to a respective trigger point and represent a memory address of an instruction or memory address to be monitored associated with the trigger point. Additionally, the LUTs are generated by a host device based on the source code of the program, the metrics (e.g., control flow integrity, code/memory integrity, input/output (I/O) tracing, execution timing, etc.) being assessed for the program, or both. As an example, based on the metrics to be assessed for the program, the host device identifies one or more points of interest in the source code each representing the addresses of corresponding instructions, addresses for memory observation, or both to be assessed. For one or more of these identified points of interest, the host device generates an entry for a LUT that includes the memory address associated with the point of interest, a gadget (e.g., set of commands) to be executed for the point of interest, and one or more successor points of interest. After generating one or more LUTs in this way, the host device uploads the LUTs to the TPIC memory of the DUT board.

After the LUTs are uploaded to the TPIC memory, the host device loads machine-readable compiled code (e.g., binary code) of the program into the system (e.g., DUT) memory, and the processor core begins execution of the program. As the program is executing, the TPIC, debug circuitry, or both monitor the execution of the program based on the LUTs. For example, after a trigger point in the program has been reached, the TPIC, debug circuitry, or both check the memory address currently accessed by the processor. For example, the TPIC, debug circuitry, or both request the processor to identify the memory address currently being accessed, check a program counter, check one or more registers, or any combination thereof to determine the memory address currently being accessed by the processor. After determining the memory address currently being accessed by the processor, the TPIC then compares this memory address to the memory addresses of the points of interest indicated in the LUTs to determine if a point of interest has been reached. Based on the memory address currently being accessed by the processor not matching the memory address of a point of interest in any entry of the LUTs, the TPIC determines that the memory address is not identified by the LUTs and is configured to continue execution of the application, modify a program counter, abort the debugging process, or any combination thereof. As an example, based on the currently accessed memory address not matching a point of interest in any entry of the LUTs, the TPIC sends one or more signals to the debug circuitry that causes the debug circuitry to increment the program counter of the processor which causes the processor to execute a next instruction based on the incremented program counter (e.g., execute the instruction at the next address pointed to by the program counter). As another example, based on the currently accessed memory address of the program counter not matching a point of interest in any entries of the LUTs, the TPIC sends one or more signals to the debug circuitry that causes the debug circuitry to end execution of the program by the processor.

Further, based on the currently access memory address matching the point of interest in an entry of the LUTs, the TPIC determines that a point of interest has been reached. In response to a point of interest being reached, the TPIC executes one or more gadgets indicated in the entry associated with the identified point of interest. Such a gadget, for example, includes a set of commands stored in the TPIC memory that, when executed, cause the TPIC to assess one or more metrics of the execution of the program by the processor core. As an example, a gadget includes one or more commands that, when executed, cause the TPIC to read, write, modify, or any combination thereof data at one or more memory addresses at one or more memory locations associated with the metrics to be assessed; store data read from these memory addresses in one or more buffers of the TPIC or the memory of the TPIC; or both. As another example, the gadget includes instructions that cause the TPIC to use the debug circuitry to read, write, modify, or any combination thereof data at one or more memory addresses at one or more memory locations associated with the metrics to be assessed; store data read from these memory addresses in one or more buffers of the TPIC or the memory of the TPIC; or both. Further, the TPIC is configured to report the data resulting from the execution of one or more gadgets to the host device. As an example, asynchronously with the execution of the program, the TPIC reports this data to the host device. In other embodiments, the TPIC reports the data to the host drive synchronously with the execution of the program.

After executing a gadget, the TPIC instructs the processor to continue execution of the program and continues to monitor for points of interest according to the uploaded LUT. For example, each time a trigger point is reached while the processor executes the program, the TPIC determines whether a point of interest has been reached based on the LUTs. The TPIC then continues monitoring for points of interest in this manner until the program is aborted or terminated due to the end of the program being reached, a predetermined timeout being reached, a memory address not matching an entry in the LUTs, or the like. However, when assessing certain metrics of an application, the TPIC is instead configured to evaluate the instruction at the memory address currently accessed by the processor. For example, the TPIC determines whether the instruction indicates another point of interest. That is, the TPIC determines whether the instruction indicates one or more successor points of interest identified in the entry of the LUTs that included the point of interest matching the currently access memory address. For example, based on the instruction being a control flow instruction, the TPIC determines whether the memory address of the next instruction indicated by the control flow instruction (e.g., the address of the jump indicated by the control flow instruction) corresponds to one or more successor points of interest of the entry. Based on the memory address of the next instruction indicated by the control flow instruction not corresponding to any successor points of interest in the entry, the TPIC determines that the next memory address is unknown and instructs the processor to step to the next sequential instruction. Further, based on an instruction not being a control flow instruction or based on the memory address of the next instruction indicated by the control flow instruction corresponding to a successor point of interest indicated in the entry, the TPIC instructs the processor, via for example the debug circuitry, to continue execution of the program. While the processor core continues execution of the program, the TPIC, for example, monitors the program counter of the processor core to determine whether the memory address pointed to by the program counter matches one or more points of interest indicated in the entries of the LUT.

In this way, the debugging system is configured to use hardware (e.g., the TPIC) to control the debug circuitry and monitor the execution of the program by the processor when a trigger point is reached. Due to using such hardware, the time needed to evaluate the execution of the program is reduced when compared to typical debugging systems that require a host device to directly program or control the debug circuitry. For example, a typical debugging system uses a host device at runtime to instruct the debug circuitry to read, write, or modify data at certain memory addresses each time a trigger point is reached which adds additional time to the debugging process due to the time needed for the host device to command the debug circuitry. However, the LUTs used by the TPIC allow the TPIC to determine what data to read, write, or modify data at certain memory addresses each time a trigger point is reached without any instruction from the host device at runtime, reducing the time needed to evaluate the program after a trigger point is reached.

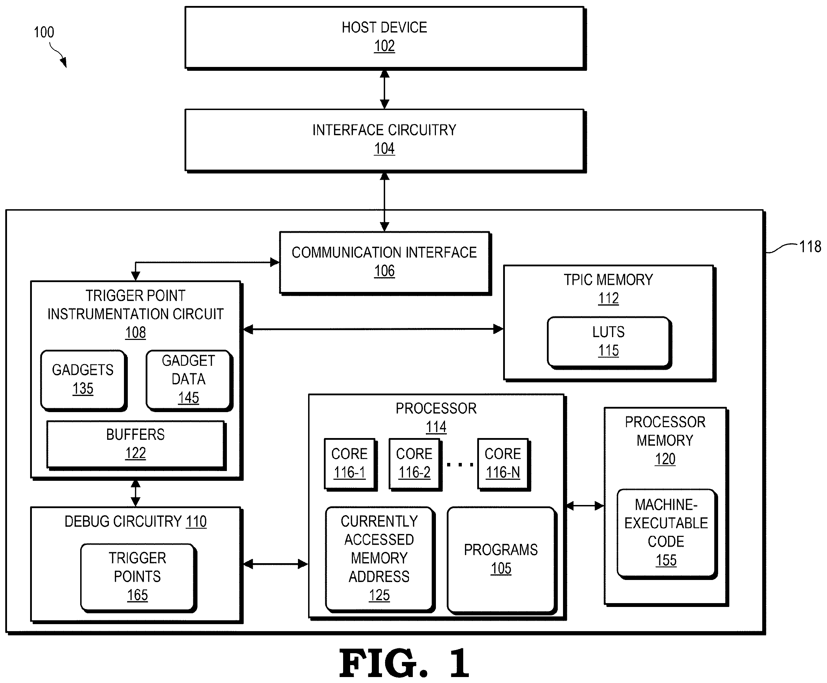

Referring now to FIG. 1, an example system 100 that includes a TPIC configured to execute sets of commands when points of interest in a program are reached is presented, in accordance with embodiments. In embodiments, system 100 is configured to evaluate the execution of one or more programs 105 associated with one or more types of software such as control software, media software, connectivity software, and the like. These programs 105, for example, each include machine-executable code 155 (e.g., binary code) that represents one or more instructions to be executed for the program 105. To evaluate the execution of a program 105, system 100 includes DUT board 118 or another processing system that includes one or more traces, connectors, contacts, switches, and the like configured to communicatively couple one or more components (e.g., communication interface 106, TPIC 108, debug circuitry 110, TPIC memory 112, processor 114, processor memory 120) of DUT board 118 to one another. According to embodiments, to execute one or more programs 105, DUT board 118 includes processor memory 120 implemented as dynamic random-access memory (DRAM), static random-access memory (SRAM), volatile random-access memory (RAM), nonvolatile RAM, and the like configured to store data used in the execution of one or more programs 105 such as machine-executable code 155, variables, register files, operands, and the like. This machine-executable code 155, as an example, represents a machine-readable compiled code such as a binary code or other type of compiled executable code that indicates one or more instructions to be executed for a corresponding program 105. Further, DUT board 118 includes processor 114 configured to execute a program 105 based on the machine-executable code 155 in processor memory 120. In embodiments, processor 114, for example, includes a central processing unit (CPU) having an instruction set architecture configured to execute instructions of a corresponding instruction type for a program 105. As an example, processor 114 includes a CPU having a reduced instruction set computer (RISC) architecture configured to execute RISC instructions for a program 105. Additionally, processor 114 includes one or more processor cores 116 each configured to execute instructions associated with the instruction set architecture of the processor 114. For example, a processor core 116 includes one or more arithmetic logic units (ALUs), GPRs, CSRs, integer registers, or any combination thereof configured to execute one or more instructions for a program 105. Though the example embodiment presented in FIG. 1 shows processor 114 as having three processor cores (116-1, 116-2, 116-N) representing an N integer number of processor cores, in other embodiments, processor 114 may have any non-zero integer number of processor cores 116.

To assess the execution of a program 105 by processor 114, DUT board 118 includes debug circuitry 110 and TPIC 108. Debug circuitry 110 includes one or more microcontrollers, microprocessors, programmable logic devices, memories, storages, or the like configured to read, write, modify, or any combination data from one or more memory addresses of one or more memory locations (e.g., GPRs, CSRs, integer registers, caches, processor memory 120, system memory). TPIC 108, for example, includes an integrated circuit with one or more microcontrollers, microprocessors, programmable logic devices, storages, buffers 122, or any combination thereof configured to monitor for one or more points of interest and execute one or more gadgets 135 in response to a point of interest being reached. These points of interest, for example, represent certain points within the program 105 during which the TPIC 108, debug circuitry 110, or both are to read, write, modify, or any combination thereof data at one or more memory addresses of one or more memory locations so as to assess one or more metrics of the execution of the program 105. Such metrics, for example, include regular instruction, control flow integrity, code/memory integrity, input/output (I/O) tracing, data tracing, execution timing of one or more functions, or the like. In some embodiments, TPIC 108 includes an integrated circuit distinct from processor 114, processor memory 120, debug circuitry 110, communication interface 106, or any combination thereof. Further, according to some embodiments, TPIC 108 is implemented within debug circuitry 110.

To enable TPIC 108 to determine whether a point of interest in a program 105 has been reached, TPIC 108 includes or is otherwise connected to TPIC memory 112 which includes one or more storages, SRAM, DRAM, volatile RAM, nonvolatile RAM, or the like configured to store one or more LUTs 115. These LUTs 115, for example, include data representing one or more points of interest for a program 105 and one or more corresponding gadgets 135 to be executed for each point of interest. As an example, the LUTs 115 include entries each indicating the memory address (e.g., memory address in system 100) of an instruction or memory address to be monitored that represents a point of interest within the program 105; one or more gadgets 135 to execute when that point of interest is reached; one or more successor points of interests (e.g., points of interests that will be reached after reaching the point of interest in the entry); or any combination thereof. According to embodiments, TPIC 108 is configured to determine whether a point of interest in the program 105 has been reached in response to the processor 114 reaching a trigger point 165 in the program 105. A trigger point 165, for example, includes a hardware breakpoint, watchpoint (e.g., memory watchpoint), or other address-based monitoring points associated with a program 105. As an example, in embodiments, a trigger point 165 (e.g., a hardware breakpoint) represents the memory addresses of one or more instructions to be executed for the program 105. As another example, in embodiments, a trigger point 165 (e.g., memory watch points) represents one or more memory locations (e.g., memory addresses of registers, caches, processor memory 120, system memory) that are to be accessed (e.g., read from, written to, modified) while the program 105 is executing. According to embodiments, such trigger points 165 are set by host device 102, debug circuitry 110, TPIC 108, or any combination thereof. As an example, host device 102 is configured to set one or more registers of debug circuitry 110 as to as to set one or more trigger points 165 (e.g., hardware breakpoints). As another example, host device 102 provides data to debug circuitry 110 indicating one or more trigger points 165 (e.g., memory watchpoints).

As processor 114 is executing a program 105, debug circuitry 110 is configured to determine when one or more trigger points 165 are reached (e.g., whether processor 114 has reached a trigger point 165 while executing the program 105). For example, debug circuitry 110 monitors one or more registers, requests data from processor 114, requests data from a program counter of processor 114, or the like to determine what memory address is currently being accessed by processor 114 (represented in FIG. 1 as the currently accessed memory address 125). In response to the currently accessed memory address 125 corresponding to a set trigger point 165, debug circuitry 110 determines that a trigger point 165 has been reached and places processor 114 in a debugging mode such that processor 114 suspends execution of the program 105. Concurrently with processor 114 being in a debugging mode, TPIC 108 checks the memory address currently accessed by processor 114 (e.g., checks the currently accessed memory address 125) to determine whether a point of interest has been reached. For example, TPIC 108, debug circuitry 110 (e.g., on behalf of TPIC 108), or both checks one or more registers, requests data from processor 114, requests data from a program counter of processor 114, or any combination thereof to determine the currently accessed memory address 125. TPIC 108 then compares the currently accessed memory address 125 to the entries in the LUTs 115. In response to determining that the currently accessed memory address 125 does not match any entry of the LUTs 115 stored in TPIC memory 112, TPIC 108 determines that the currently accessed memory address 125 is unknown to the LUTs 115 (e.g., to TPIC 108). Based on the currently accessed memory address 125 being unknown to the LUTs 115, in some embodiments, TPIC 108 continues execution of the program 105, aborts execution of the program 105, generates one or more signals indicating the LUTs 115 require updating, or a combination thereof. Additionally, in other embodiments, based on the currently accessed memory address 125 being unknown to the LUTs 115, TPIC 108, debug circuitry 110, or both are configured to instruct the program counter of the processor core 116 to increment to another instruction (e.g., step over an instruction).

Further, in response to determining that the currently accessed memory address 125 does match an entry of an LUT 115 stored in TPIC memory 112, TPIC 108 determines that a point of interest has been reached. In response to a point of interest being reached, the TPIC 108 executes one or more gadgets 135 indicated in the entry including the point of interest that matches the currently accessed memory address 125. A gadget 135, for example, includes a set of commands stored in the TPIC memory 112 that, when executed, cause the TPIC 108, debug circuitry 110, or both to assess one or more metrics of the execution of the program 105 by processor 114. As an example, a gadget 135 includes one or more commands that, when executed, cause the TPIC 108, debug circuitry 110 (e.g., on behalf of the TPIC 108), or both to read, write, modify, or any combination thereof data at one or more memory addresses of one or more memory locations (e.g., GPRs, CSRs, integer registers, caches, processor memory 120, system memory). Further, in some embodiments, a gadget 135 includes one or more commands that, when executed, cause the TPIC 108, debug circuitry 110, or both to store data read out of one or more memory addresses into one or more buffers 122 of the TPIC 108, the TPIC memory 112, or both. Within FIG. 1, such data read out of one or more memory addresses and stored in one or more buffers 122 of the TPIC 108, the TPIC memory 112, or both during the execution of a gadget 135 is represented as gadget data 145. Additionally, in embodiments, TPIC 108 is configured to report gadget data 145 to a host device 102. For example, after gadget data 145 has been stored in one or more buffers 122 of the TPIC 108, the TPIC memory 112, or both, the TPIC 108 reports the gadget data 145 to a host device 102. In embodiments, asynchronously with the execution of the program 105, TPIC 108 is configured to report the gadget data 145 to the host device 102. In other embodiments, TPIC 108 is configured to report the gadget data 145 to the host device 102 synchronously with the execution of the program 105.

The host device 102 includes, for example, a processor, computer, tablet computer, laptop computer, or the like and includes or is otherwise connected to an interface circuitry 104. This interface circuitry 104, for example, includes one or more connectors, microcontrollers, switches, storages, memories, or the like that enable the host device 102 to communicatively couple to one or more other devices using one or more wired communication protocols, wireless communication protocols, or both. As an example, interface circuitry 104 is configured to communicatively couple host device 102 to communication interface 106 of DUT board 118 such that host device 102 is communicatively coupled to TPIC 108, TPIC memory 112, debug circuitry 110, processor 114, processor memory 120, or any combination thereof. This communication interface 106, as an example, includes one or more connectors, microcontrollers, switches, storages, memories, or the like that enable the DUT board 118 to communicatively couple to one or more other devices using one or more wired communication protocols, wireless communication protocols, or both.

After determining that the currently accessed memory address 125 is associated with a point of interest and after executing one or more gadgets 135, TPIC 108 is configured to resume normal execution of the program 105 and continues to monitor for points of interest each time a trigger point 165 is reached. In this way, including the TPIC 108 of the DUT board 118 reduces the time needed to evaluate the execution of a program 105 when compared to typical debugging systems that require a host device 102 to instruct debug circuitry 110 each time a trigger point 165 is reached.

According to some other embodiments, when assessing certain metrics of program 105, TPIC 108 is configured to determine whether an instruction at the currently accessed memory address 125 indicates one or more subsequent points of interest after TPIC 108 has executed a gadget 135. For example, based on the instruction being a control flow instruction and based upon a subsequent instruction (e.g., jump) indicated in that control flow instruction not matching the successor points of interest in the entry having the point of interest corresponding to the address currently pointed to by a program counter of processor 114, TPIC 108 modifies the program counter, resumes execution of the program 105 (e.g., instructs debug circuitry 110 to resume execution), and continues to check for points of interest according to the LUTs 115 when trigger points 165 are reached. Further, based on the instruction not being a control flow instruction or based upon the next instruction being a control flow instruction indicating an address that matches an entry in the LUTs 115, the TPIC 108 resumes execution of the program 105 and continues to check for points of interest according to the successor points of interest indicated in the entry.

According to embodiments, the LUTs 115 stored in TPIC memory 112 are generated by host device 102. For example, to generate one or more LUTs 115, host device 102 is configured to first parse through the source code (e.g., uncompiled source code) of a program 105 to identify one or more points of interest. As an example, host device 102 identifies one or more points of interest (e.g., instructions, memory addresses to monitor) in the source code based on the metrics sought to be assessed for the execution of the program 105. After identifying a point of interest, the host device 102 determines one or more gadgets 135 each associated with the point of interest in the source code. That is, the host device 102 determines one or more gadgets 135 configured to read, write, modify, or any combination thereof data at one or more memory addresses that helps assess one or more desired metrics of the execution of the program 105, modify system states (e.g., modify data in GPRs, CSRs, processor memory 120, system memory), or both when a corresponding point of interest is reached. Further, the host device 102 is configured to perform one or more static analysis techniques on the source code 403 to generate a control flow graph that represents all the potential paths (e.g., statements and decision points) to be traversed when the program 105 is executed. For each identified point of interest, the host device 102 then uses the control flow graph to determine which other identified points of interest are next in the execution path. That is, the host device 102 determines successor points of interest for each point of interest. The host device 102 then generates one or more LUTs 115 having entries that indicate a corresponding point of interest, gadgets associated with that point of interest, and successor points of interest associated with the point of interest. In embodiments, after generating LUTs 115, host device 102 is configured to store the LUTs 115 in TPIC memory 112.

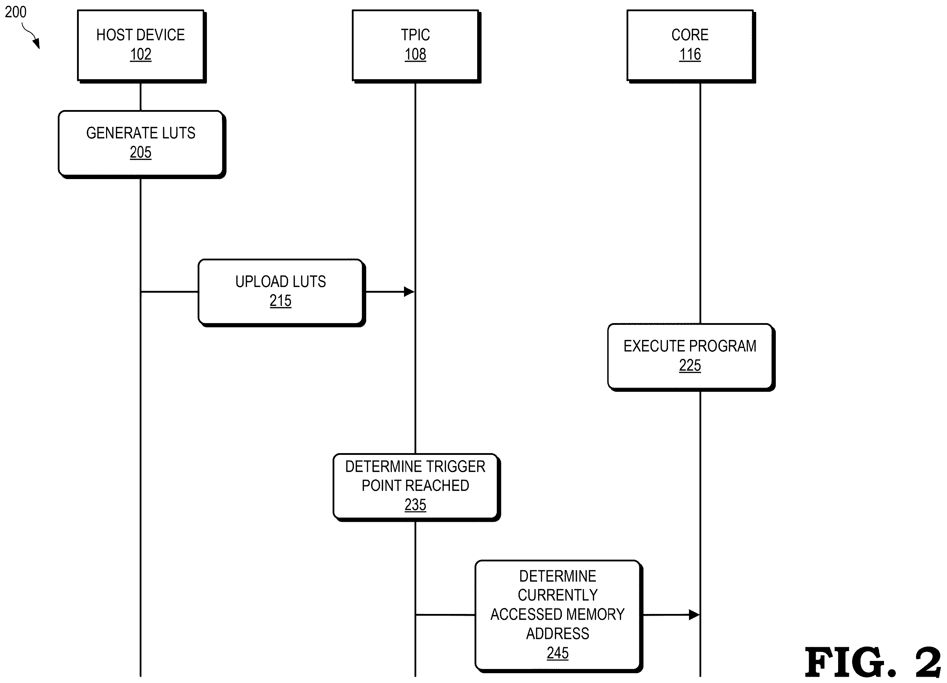

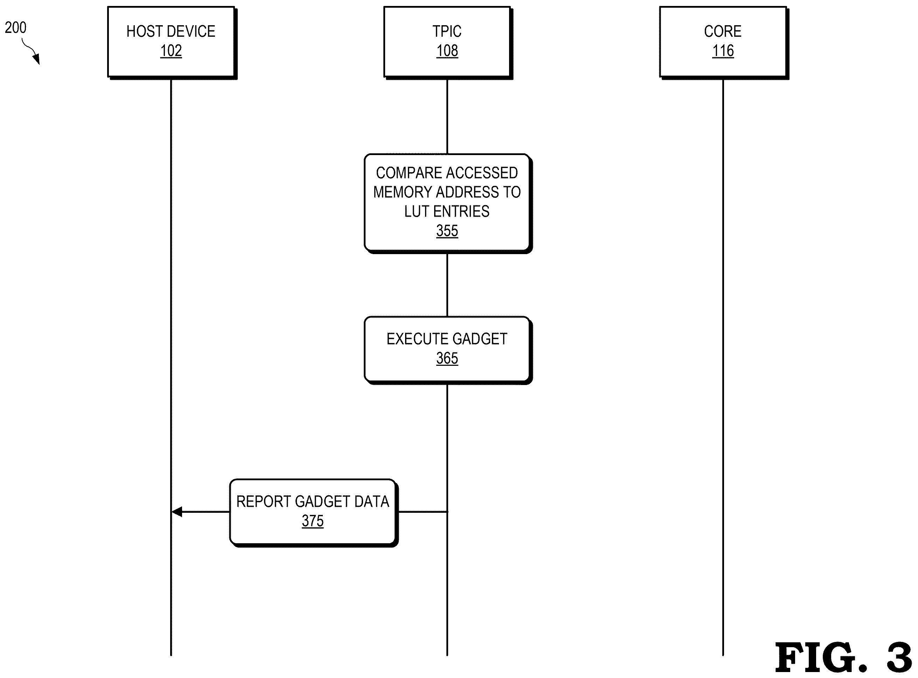

FIGs. 2 and 3 together present an example operation 200 that uses a TPIC to execute sets of commands when a point of interest is reached, in accordance with some embodiments. In embodiments, example operation 200 is implemented at least in part by host device 102, TPIC 108, and processor 114. As an example, at block 205, example operation 200 includes host device 102 generating one or more LUTs 115 for a program 105 to be tested. These LUTs 115, for example, include entries each indicating one or more memory addresses of respective instructions or memory addresses to be monitored associated with one or more points of interest within a program 105, one or more gadgets 135 to be performed for the point of interest, successor points of interest, or any combination thereof. For example, based on the type of software associated with program 105 (e.g., control software, media software, connectivity software) and the metrics sought to be assessed, host device 102 identifies one or more instructions within the source code of the program 105 as points of interest. For each identified point of interest, the host device 102 determines one or more gadgets 135 that collect data, modify system states, or both so as to assess these metrics. As an example, the host device 102 determines a gadget 135 that reads, writes, modifies, or any combination thereof data at one or more memory addresses of one or more memory locations (e.g., GPRs, CSRs, integer registers, caches, processor memory 120, system memory) associated with the point of interest. As another example, the host device 102 determines a gadget that stores data read out of one or more memory addresses associated with the point of interest into a buffer 122 of TPIC 108, TPIC memory 112, or both. Additionally, in some embodiments, the host device 102 performs one or more static analysis techniques on the source code of the program 105 to generate a control flow graph for the program 105. Based on this control flow graph, the host device 102 determines successor points of interest for each point of interest (e.g., points of interest to be executed after a corresponding point of interest). The host device then generates one or more LUTs 115 that include entries each indicating a point of interest (e.g., memory address representing the points of interest), gadgets associated with the point of interest, successor points of interest, or any combination thereof. At block 215 of example operation 200, the host device 102 stores the generated LUTs 115 for the program 105 in TPIC memory 112.

After uploading the LUTs 115, at block 225, processor 114 is configured to start executing the program 105. For example, processor 114 first retrieves the instruction at the memory address (e.g., address in processor memory 120) currently pointed to by a program counter and executes the instruction. At block 235, debug circuitry 110 determines that a trigger point 165 has been met and places the processor 114 in a debugging state. For example, debug circuitry 110 checks one or more registers, requests data from processor 114, requests data from a program counter of processor 114, or any combination thereof to determine the memory addresses currently accessed by processor 114 (e.g., the currently accessed memory address 125). In response to the currently accessed memory address 125 being associated with a set trigger point 165, debug circuitry 110 determines that a trigger point 165 has been met. After debug circuitry 106 has determined a trigger point 165 has been met, at block 245, the TPIC 108 is configured to determine the currently accessed memory address 125. For example, the TPIC 108 checks one or more registers, requests data from debug circuitry 110, requests data from processor 114, requests data from a program counter of processor 114, or any combination thereof to determine the currently accessed memory address 125.

Referring now to FIG. 3, after determining the currently accessed memory address 125, at block 355, TPIC 108 compares the currently accessed memory address 125 to the entries of the LUTs 115 to determine if a point of interest has been reached. That is to say, TPIC 108 compares the currently accessed memory address 125 to the memory addresses representing points of interest in the LUTs 115 to determine if a point of interest has been reached. In response to determining that a point of interest has been reached, at block 365, TPIC 108 is configured to execute one or more gadgets 135 associated with the determined point of interest. For example, for each entry of the LUTs 115 having a point of interest that matches the currently accessed memory address 125, TPIC 108 executes the gadget 135 identified in that entry. In embodiments, each gadget 135 includes a corresponding set of commands that, when executed by TPIC 108, cause TPIC 108 to read, write, modify, or any combination thereof data at one or more memory addresses of one or more memory locations associated with the corresponding point of interest. As an example, a gadget 135 includes commands that, when executed, cause TPIC 108 to read gadget data 145 from one or more memory addresses and store such gadget data 145 in one or more buffers 122, TPIC memory 112, or both. In embodiments, a gadget 135 includes commands that, when executed by TPIC 108, cause TPIC 108 to send one or more signals to debug circuitry 110 that cause debug circuitry 110 to read, write, modify, or any combination thereof data at one or more memory addresses of one or more memory locations associated with the corresponding point of interest. After TPIC 108 has executed one or more gadgets 135 associated with the point of interest, at block 375, TPIC 108 reports the gadget data 145 resulting from the execution of one or more gadgets 135 to the host device 102. As an example, TPIC 108 reports gadget data 145 stored in one or more buffers 122 of TPIC 108, TPIC memory 112, or both to the host device 102 asynchronously with the execution of the program 105.

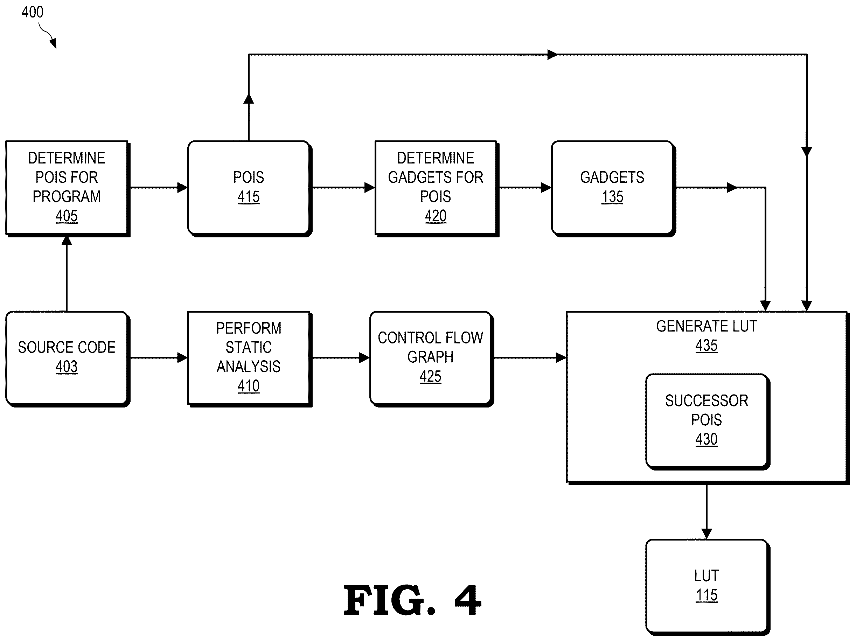

Referring now to FIG. 4, an example process 400 for generating one or more LUTs for a TPIC is presented, in accordance with some embodiments. In embodiments, example process 400 is implemented by host device 102 to generate one or more LUTs 115. For example, at block 405 of example process 400, host device 102 is configured to determine one or more points of interest (POIs) 415 in a program 105 to be executed. These POIs 415, for example, each represent a point within the source code 403 (e.g., uncompiled source code) of program 105 wherein data is to be read, written, modified, or any combination thereof so as to help assess execution of the program 105. For example, based on the type of software associated with the program 105, the host device 102 parses through the source code 403 associated with the program 105 and identifies one or more instructions or memory addresses to monitor helpful in assessing control flow attestation, memory access checks, instruction flow analysis, data flow analysis, watchpoints, performing profiling, code coverage, non-invasive logging (e.g., no explicit calls for logging functions), fault injection testing, concurrency analysis, or any combination thereof, to name a few. Based on the identified instructions and memory addresses to monitor, the host device 102 generates a POI 415 that indicates the memory address of the identified instruction or memory address to monitor. As an example, based on the type of software associated with the program 105, the host device 102 parses the source code 403 associated with the program 105 and identifies one or more calling instructions, returning instructions, or both helpful in determining how long each function of the program 105 is executed (e.g., performance profiling of the program 105). The host device 102 then generates a first POI 415 indicating the address of a calling instruction and a second POI 415 indicating the address of the returning instruction associated with the calling instruction.

After generating one or more POIs 415, at block 420, the host device 102 is configured to generate a gadget 135 for each determined POI 415. As an example, based on the type of software associated with the program 105, the memory address indicated by the POI 415, the type of instruction indicated by the POI 415, or any combination thereof, the host device 102 generates a gadget 135 for a POI 415 that includes commands to read, write, modify, or any combination thereof data from one or more memory addresses of one or more memory locations (e.g., registers, caches, processor memory 120, system memory) associated with the POI 415 (e.g., helpful in assessing one or more metrics of the program 105 at the POI 415). As an example, a gadget 135 includes commands to read data (e.g., gadget data 145) from one or more memory addresses associated with the POI 415 and store the read gadget data 145 in one or more buffers 122, TPIC memory 112, or both. In some embodiments, based on the POI 415 indicating a calling instruction, the host device 102 generates a gadget 135 that includes commands to read, write, modify, or any combination thereof data of one or more registers of processor 114, processor memory 120, or both indicating one or more times associated with the calling instruction (e.g., a time indicating when the calling instruction was completed, a time indicating when the calling instruction was initiated) and store this data in the buffers 122 of TPIC 108, TPIC memory 112, or both. In some other embodiments, based on the POI 415 indicating a returning instruction, the host device 102 generates a gadget 135 that includes instructions to read, write, modify, or any combination thereof data from one or more registers of processor 114, processor memory 120, or both indicating one or more times associated with the return instruction (e.g., a time indicating when the returning instruction was completed, a time indicating when the returning instruction was initiated) and store this data in the buffers 122 of TPIC 108, TPIC memory 112, or both.

At block 410, host device 102 is configured to perform one or more static analysis operations on the source code 403 of the program 105 so as to determine a control flow graph 425 for the program 105. As an example, host device 102 performs one or more static analysis operations to determine the execution path of the instructions of the program 105 and generates a control flow graph 425 representing these execution paths. Such a control flow graph 425, for example, includes data representing all execution paths (e.g., paths and alternate paths) that may be taken by a processor core 116 when executing the program 105. After generating one or more POIs 415, gadgets 135, and control flow graph 425, at block 435, the host device 102 is configured to generate one or more LUTs 115 based on one or more POIs 415, one or more gadgets 135, and control flow graph 425. For example, for each POI 415, the host device 102 generates an entry for an LUT 115 that includes data indicating the POI 415, one or more gadgets 135 generated for the POI 415 (e.g., one or more corresponding sets of commands), one or more successor POIs 430, or any combination thereof. These successor POIs 430, for example, each represent an address of an instruction that is to be executed after the instruction represented by the POI 415 of the entry. According to embodiments, the host device 102 is configured to determine one or more successor POIs 430 for an entry of an LUT 115 based on the control flow graph 425. For example, from the control flow graph 425, the host device 102 determines one or more instructions that are to be executed after the instruction represented by the POI 415 of the entry. The host device 102 then compares these instructions to the POIs 415 generated at block 405. Based on an instruction matching a POI 415, the host device 102 stores data in the entry of the LUT 115 indicating a successor POI 430 that represents the address of the instruction. Further, in some embodiments, branching and indirect jumps within a program 105 may prevent host device 102 from determining one or more successor POIs for one or more entries of the LUTs 115. As such, according to some embodiments, the host device 102 is configured to generate one or more entries for one or more LUTs 115 that indicate a POI 415 and successor POIs 430 but does not identify any gadgets 135 to be executed. In this way, a TPIC 108 using the LUTs 115 is enabled to advance execution of the program 105 and set points of interest even during such branching and indirect jumps.

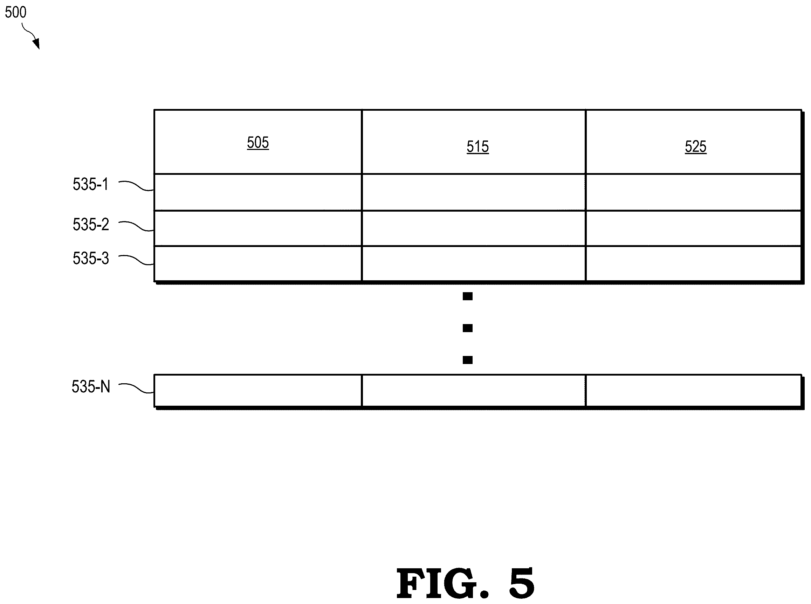

Referring now to FIG. 5, an example LUT 500 is presented, in accordance with some embodiments. In embodiments, example LUT 500 is implemented within system 100 as one or more LUTs 115. Example LUT 500 includes, for example one or more entries 535 each including data indicating a POI 505, one or more gadgets to be executed 515 (e.g., one or more corresponding sets of commands to be executed), and one or more successor POIs 525. As an example, based on example LUT 500 being generated to assess the completion time of functions in a program 105, example LUT 500 includes a first entry 535-1 including data that indicates a POI 505, similar to or the same as a POI 415, that represents the memory address of a calling instruction of a program 105. Further, the first entry 535-1 includes data indicating a gadget to be executed 515, similar to or the same as gadgets 135, that includes instructions that, when executed, cause the TPIC 108 to read data from one or more registers of a processor core 116, processor memory 120, or both that indicates a time when the calling instruction was initiated, a time when the calling instruction was completed, or both and store this data in one or more buffers 122 of the TPIC 108, TPIC memory 112, or both. Additionally, the first entry 535-1 includes data indicating one or more successor POIs 525, similar to or the same as successor POIs 430, that indicate the memory addresses of one or more instructions to be performed after the calling instruction, such as a returning instruction. Further, example LUT 500 includes a second entry 535-2 that includes data indicating a POI 505 that represents the address of a returning instruction of the program 105. Additionally, the second entry 535-2 includes data indicating a gadget to be executed 515 that includes the TPIC 108 reading data from one or more registers of a processor core 116, processor memory 120, or both that indicates a time when the returning instruction was initiated, a time when the returning instruction was completed, or both and storing this data in one or more buffers 122 of the TPIC 108, TPIC memory 112, or both. The second entry 535-2 also includes data indicating one or more successor POIs 525 that represents the addresses of instructions to be performed after the returning instruction.

According to some embodiments, example LUT 500 includes one or more entries 535 with data indicating a corresponding POI 505 and one or more successor POIs 525 but not data indicating one or more gadgets to be executed 515. Such entries, for example, are used by TPIC 108 to advance the execution of a program 105 and set points of interest during branching and indirect jumps of the program 105. Though the example embodiment shows example LUT 500 as including four entries (535-1, 535-2, 535-3, 535-N) representing an N integer number of entries, in other embodiments, LUT 500 includes any non-zero integer number of entries 535.

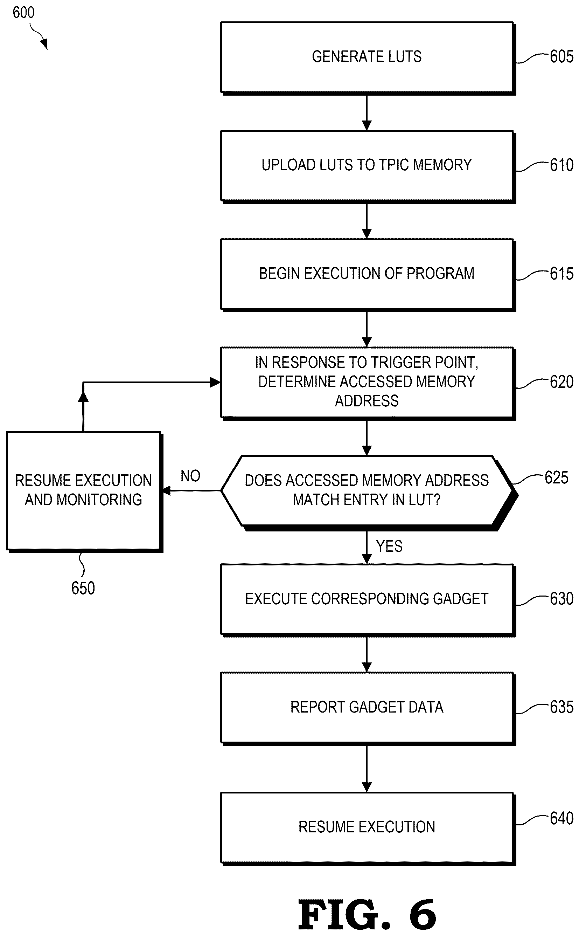

Referring now to FIG. 6, an example method 600 for debugging a program using a TPIC is presented, in accordance with some embodiments. In embodiments, example method 600 is implemented at least in part by host device 102, TPIC 108, debug circuitry 110, a processor core 116, or any combination thereof, to name a few. Example method 600 includes, at block 605, the host device 102 generating one or more LUTs 115. For example, the host device 102 first parses the source code 403 of a program 105 to determine one or more POIs 415 and corresponding gadgets 135 for each POI 415. Additionally, in some embodiments, the host device 102 performs one or more static analysis operations to produce a control flow graph 425 for the program 105. Using this control flow graph 425, the host device 102 determines one or more successor POIs 430 for one or more of the determined POIs 415 of the program 105. The host device 102 then generates one or more entries 535 based on the determined POIs 415, gadgets 135, successor POIs 430, or any combination thereof to generate one or more LUTs 115. After generating these LUTs 115, at block 610, the host device 102 uploads the LUTs 115 to a TPIC memory 112 of a DUT board 118. That is, before a processor core 116 begins executing the program 105, the host device 102 uploads the LUTs 115 to the TPIC memory 112. At block 615, processor 114 of the DUT board 118 begins executing the program 105.

Concurrently with processor 114 executing the program 105, at block 620, debug circuitry 110 of the DUT board 118 determines that processor 114 has reached one or more trigger points 165. After reaching this trigger point 165, TPIC 108 then determines whether a POI 415 indicated in the LUTs 115 has been reached. For example, the TPIC 108 requests the memory address currently accessed by processor 114 (e.g., the currently accessed memory address 125) by checking one or more registers, requesting data from debug circuitry 110, requesting data from processor 114, requesting data from a program counter of processor 114, or any combination thereof. At block 625, the TPIC 108 determines whether the currently accessed memory address 125 matches the POIs 415 indicated in the entries 535 of the LUTs 115. In response to the currently accessed memory address 125 not matching the POI 415 indicated in any entry 535 of the LUTs 115, at block 650, TPIC 108 determines that the currently accessed memory address 125 is unknown. In some embodiments, in response to determining that the currently accessed memory address 125 is unknown, TPIC 108 has processor 114 resume normal execution of the program 105 and continues to monitor for POIs 415 in response to trigger points 165 being met. For example, TPIC 108 repeats block 620 and again determines the memory address currently accessed by processor 114. Based on the currently accessed memory address 125 matching the POI 415 indicated in an entry 535 of the LUTs 115, at block 630, the TPIC 108 executes the gadget 135 indicated in the entry 535. While executing the gadget 135, TPIC 108, debug circuitry 110, or both are configured to read, write, modify, or any combination thereof data at one or more memory addresses of one or more memory locations (e.g., GPRs, CSRs, integer registers, caches, processor memory 120, system memory) as indicated by the gadget 135. That is to say, TPIC 108, debug circuitry 110, or both are configured to read, write, modify, or any combination thereof data at one or more memory addresses of one or more memory locations (e.g., GPRs, CSRs, integer registers, caches, processor memory 120, system memory) that helps assess one or more metrics (e.g., completion time, temperature, power used, resources used) of the execution of the program 105 at the POI 415 associated with the gadget 135. According to embodiments, TPIC 108, debug circuitry 110, or both store data read out for a gadget 135 (e.g., gadget data 145) in one or more buffers 122 of TPIC 108, TPIC memory 112, or both. After one or more gadgets 135 have been executed, at block 635, the TPIC 108 is configured to report gadget data 145 resulting from the executed gadgets 135 to the host device 102. For example, asynchronously with the execution of the program 105 by the processor core 116, TPIC 108 reports the gadget data 145 to the host device via a communication interface 106 of the DUT board 118. At block 640, the TPIC 108 is configured to resume execution of the program 105 by processor 114.

In some embodiments, certain aspects of the techniques described above may be implemented by one or more processors of a processing system executing software. The software comprises one or more sets of executable instructions stored or otherwise tangibly embodied on a non-transitory computer-readable storage medium. The software can include the instructions and certain data that, when executed by the one or more processors, manipulate the one or more processors to perform one or more aspects of the techniques described above. The non-transitory computer-readable storage medium can include, for example, a magnetic or optical disk storage device, solid-state storage devices such as Flash memory, a cache, random access memory (RAM) or other non-volatile memory device or devices, and the like. The executable instructions stored on the non-transitory computer-readable storage medium may be in source code, assembly language code, object code, or other instruction format that is interpreted or otherwise executable by one or more processors.

A computer-readable storage medium may include any storage medium, or combination of storage media, accessible by a computer system during use to provide instructions and/or data to the computer system. Such storage media can include but is not limited to, optical media (e.g., compact disc (CD), digital versatile disc (DVD), Blu-Ray disc), magnetic media (e.g., floppy disc, magnetic tape, or magnetic hard drive), volatile memory (e.g., random access memory (RAM) or cache), non-volatile memory (e.g., read-only memory (ROM) or Flash memory), or microelectromechanical systems (MEMS)-based storage media. The computer-readable storage medium may be embedded in the computing system (e.g., system RAM or ROM), fixedly attached to the computing system (e.g., a magnetic hard drive), removably attached to the computing system (e.g., an optical disc or Universal Serial Bus (USB)-based Flash memory) or coupled to the computer system via a wired or wireless network (e.g., network accessible storage (NAS)).

Note that not all of the activities or elements described above in the general description are required, that a portion of a specific activity or device may not be required, and that one or more further activities may be performed, or elements included, in addition to those described. Still further, the order in which activities are listed is not necessarily the order in which they are performed. Also, the concepts have been described with reference to specific embodiments. However, one of ordinary skill in the art appreciates that various modifications and changes can be made without departing from the scope of the present disclosure as set forth in the claims below. Accordingly, the specification and figures are to be regarded in an illustrative rather than a restrictive sense, and all such modifications are intended to be included within the scope of the present disclosure.

Benefits, other advantages, and solutions to problems have been described above with regard to specific embodiments. However, the benefits, advantages, solutions to problems, and any feature(s) that may cause any benefit, advantage, or solution to occur or become more pronounced are not to be construed as a critical, required, or essential feature of any or all the claims. Moreover, the particular embodiments disclosed above are illustrative only, as the disclosed subject matter may be modified and practiced in different but equivalent manners apparent to those skilled in the art having the benefit of the teachings herein. No limitations are intended to the details of construction or design herein shown, other than as described in the claims below. It is therefore evident that the particular embodiments disclosed above may be altered or modified and all such variations are considered within the scope of the disclosed subject matter. Accordingly, the protection sought herein is as set forth in the claims below.

## Claims

1. A system, comprising:
a memory including one or more lookup tables (LUTs); and
a trigger point instrumentation circuit (TPIC) configured to, in response to a trigger point of a program being reached by a processor, execute a set of commands indicated in an entry of the one or more LUTs based on a memory address currently accessed by the processor matching the entry of the one or more LUTs.

2. The system of claim 1, wherein the TPIC comprises an integrated circuit distinct from the memory and the processor.

3. The system of claim 1 or 2, wherein the TPIC is configured to:
in response to executing the set of commands, read data from one or more memory addresses of the system; and
report the data to a host device.

4. The system of any preceding claim, further comprising:
a debug circuitry configured to suspend execution of the program in response to the trigger point of the program being reached by the processor.

5. The system of claim 4, wherein the TPIC is implemented in the debug circuitry.

6. The system of claim 4 or 5,wherein the TPIC is configured to:
resume execution of the program based on the address currently accessed by the processor not matching a point of interest in any entry of the one or more LUTs.

7. The system of any preceding claim, wherein the trigger point represents a hardware breakpoint or a memory watchpoint.

8. A method, comprising:
storing, in a memory of a trigger point instrumentation circuit (TPIC), one or more lookup tables (LUTs) including entries each indicating a corresponding point of interest of a program;
executing, by a processor, the program; and
in response to the processor reaching a trigger point in the program, executing, by the TPIC, a set of commands indicated in an entry of the one or more LUTs based on a memory address currently accessed by the processor matching the point of interest in the entry of the one or more LUTs.

9. The method of claim 8, further comprising:
parsing source code associated with the program to identify one or more points of interest; and
generating one or more entries of the one or more LUTs based on the identified one or more points of interest.

10. The method of claim 9, wherein the one or more entries each indicate a corresponding point of interest and a corresponding set of commands.

11. The method of any one of claims 8 to 10, wherein the one or more LUTs are uploaded to the memory before the processor begins executing the program.

12. The method of any one of claims 8 to 11, further comprising:
reading data from one or more memory addresses in response to executing the set of commands; and
reporting the data from the one or more memory addresses to a host device.

13. The method of any one of claims 8 to 12, further comprising:
suspending execution of the program in response to the trigger point of the program being reached by the processor.

14. The method of claim 9, further comprising:
resuming, by the TPIC, execution of the program based on the address currently accessed by the processor not matching a point of interest in any entry of the one or more LUTs.

15. The method of any one of claims 8 to 14, wherein the TPIC comprises an integrated circuit distinct from the processor.
